# FASCICULE DE BREVET EUROPEEN

(11) **EP 3 759 554 B1**
(45) Date de publication et mention de la délivrance du brevet: **05.04.2023**
(21) Numéro de dépôt: 19710495.3
(22) Date de dépôt: 21.02.2019
(51) Int. Cl.: G04D 3/00, G04B 17/06

(54) **PROCEDE DE FABRICATION D'UN SPIRAL**
HERSTELLUNGSVERFAHREN EINER SPIRALFEDER
METHOD FOR MANUFACTURING A HAIRSPRING

(30) Priorité: 01.03.2018 EP 18159345
(43) Date de publication de la demande: 06.01.2021
(73) Titulaire: CSEM Centre Suisse d'Electronique et de Microtechnique SA - Recherche et Développement, 2002 Neuchâtel (CH)
(72) Inventeur: DESPONT, Michel, 1400 Cheseaux-Noréa (CH); KOHLER, Frédéric, 1754 Avry-sur-Matran (CH); HUNZIKER, Olivier, 1800 Vevey (CH); BUCAILLE, Jean-Luc, 74160 Présilly (FR)
(74) Mandataire: Micheli & Cie SA
(86) Numéro de dépôt international: PCT/IB2019/051410
(87) Numéro de publication internationale: WO 2019/166922

(56) Documents cités:
- EP-A1- 0 732 635
- EP-A1- 2 104 007
- EP-A1- 3 181 938
- EP-B1- 0 732 635
- EP-B1- 1 422 436
- CH-A2- 711 501

## Description

La présente invention concerne un procédé de fabrication d'un spiral, c'est-à-dire d'un ressort comprenant une lame élastique en spirale. Dans une application typique, le spiral est destiné à équiper un balancier pour former avec lui le résonateur d'un mouvement horloger. Un tel spiral horloger est généralement fixé par son extrémité intérieure, par l'intermédiaire d'une virole, à un axe de balancier et par son extrémité extérieure, par l'intermédiaire d'un piton ou autre organe de fixation, à un pont du mouvement appelé « coq ».

La demande de brevet EP 3181938 de la présente demanderesse décrit un procédé de fabrication d'un spiral d'une raideur prédéterminée selon lequel a) on forme un spiral dans des dimensions supérieures aux dimensions nécessaires pour obtenir le spiral d'une raideur prédéterminée, b) on détermine la raideur du spiral ainsi formé, c) on calcule l'épaisseur de matériau à retirer pour obtenir le spiral d'une raideur prédéterminée et d) on retire du spiral formé lors de l'étape a) l'épaisseur de matériau calculée. Un tel procédé permet d'augmenter la précision dimensionnelle et de diminuer les dispersions de fabrication entre spiraux formés à partir d'une même plaquette ou de plaquettes différentes. La qualité dimensionnelle peut encore être améliorée en répétant les étapes b), c) et d). L'étape a) est par exemple réalisée par gravure d'une plaquette de silicium. L'étape d) peut alors consister à oxyder le spiral en silicium, par exemple par oxydation thermique, afin de transformer l'épaisseur de matériau à retirer en oxyde de silicium, puis à retirer l'oxyde de silicium. Après l'étape d), une opération dite de compensation thermique peut être mise en oeuvre pour rendre la raideur du spiral, plus précisément la fréquence du résonateur dont le spiral est destiné à faire partie, insensible aux variations thermiques. Dans le cas d'un spiral en silicium, on peut ainsi revêtir ce dernier d'une couche d'oxyde de silicium, par exemple par oxydation thermique, selon l'enseignement du brevet EP 1422436. Cette couche d'oxyde de silicium sert aussi à augmenter la résistance mécanique du spiral en silicium.

Une autre demande de brevet de la demanderesse, EP 3181939, décrit un procédé de fabrication d'un spiral d'une raideur prédéterminée selon lequel a) on forme un spiral dans des dimensions inférieures aux dimensions nécessaires pour obtenir le spiral d'une raideur prédéterminée, b) on détermine la raideur du spiral ainsi formé, c) on calcule l'épaisseur de matériau manquante pour obtenir le spiral d'une raideur prédéterminée et d) on modifie le spiral formé lors de l'étape a) pour compenser l'épaisseur de matériau manquante, les étapes b), c) et d) pouvant être répétées. Ce procédé aussi permet d'augmenter la précision dimensionnelle et de diminuer les dispersions de fabrication entre spiraux formés à partir d'une même plaquette ou de plaquettes différentes. L'étape a) est par exemple réalisée par gravure d'une plaquette de silicium. Après l'étape d), une opération de compensation thermique peut être mise en oeuvre pour rendre la raideur du spiral, plus précisément la fréquence du résonateur dont le spiral est destiné à faire partie, insensible aux variations thermiques. Dans le cas d'un spiral en silicium, on peut ainsi revêtir ce dernier d'une couche d'oxyde de silicium selon l'enseignement du brevet EP 1422436. Cette couche d'oxyde de silicium sert aussi à augmenter la résistance mécanique du spiral en silicium.

Selon une mise en oeuvre typique des procédés ci-dessus, plusieurs spiraux sont formés simultanément dans une même plaquette de silicium à l'étape a). Ces spiraux restent attachés à la plaquette par des ponts de matière pendant les étapes b), c) et d) ainsi que pendant l'opération de compensation thermique, et ensuite sont détachés de la plaquette. Ces ponts de matière relient radialement la spire extérieure des spiraux à la plaquette, comme illustré à la figure 7 de la demande de brevet EP 3181938 et à la figure 6 de la demande de brevet EP 3181939. Les autres spires et la virole des spiraux ne peuvent pas être attachées à la plaquette. La demande EP2104007 divulgue également de tels ponts de matière.

On comprend aisément que ce mode d'attache des spiraux à la plaquette ne permet pas de maintenir les spiraux sans déformation pendant leur fabrication, en particulier durant les opérations d'oxydation thermique pour un spiral en silicium. Lorsque la plaquette est en position horizontale, les spiraux ne restent pas plans mais prennent la forme d'une cuvette. En position verticale, la position relative des spires est modifiée, certaines spires se rapprochant les unes des autres d'un côté et s'éloignant les unes des autres de l'autre côté. A température ambiante, ces déformations n'ont pas de conséquence car elles restent élastiques. En revanche, pendant les traitements thermiques où les spiraux sont placés dans un four dont les températures peuvent être supérieures à 1000°C, ces déformations deviennent permanentes et sont même accentuées par la diminution de la rigidité du silicium. Les spiraux qui en résultent peuvent ainsi présenter entre leur extrémité intérieure et leur extrémité extérieure une différence de hauteur supérieure à la hauteur de chaque spire. Cela augmente l'encombrement des spiraux, lesquels, une fois montés dans des mouvements, peuvent entrer en contact avec d'autres composants en fonctionnement normal ou lors de chocs, ce qui peut occasionner des dommages. Ces déformations permanentes des spiraux peuvent aussi amener des spires à se toucher pendant le fonctionnement normal du mouvement ou lors de chocs et à adhérer les unes aux autres, ou à adhérer à des parties du mouvement telles que le coq. L'accès à d'autres composants du mouvement, comme la raquetterie pour le réglage de la marche, peut être empêché. De plus, ces déformations permanentes sont susceptibles d'affecter l'isochronisme.

L'ampleur de ces déformations permanentes varie selon le poids et la raideur des spires, le temps passé au four et la température du four. Il est possible de la réduire en jouant sur l'un ou l'autre de ces deux derniers paramètres mais au détriment de la productivité.

On connaît aussi par le brevet EP 0732635 de la demanderesse un procédé de fabrication d'une pièce de micromécanique selon lequel on creuse des cavités dans un substrat en laissant des parties qui constitueront ensuite des ponts de matière, on soude une plaque de matériau cristallin sur le substrat puis on grave la pièce de micromécanique dans la plaque de matériau cristallin, cette pièce ainsi que d'autres pièces d'un même lot étant alors maintenues sur le substrat par les ponts de matière. Ce procédé se poursuit par un ou des traitements complémentaires effectués sur les pièces et se termine par la rupture des ponts de matière pour détacher les pièces du substrat. Avec un tel procédé, les échanges thermiques entre la plaque de matériau cristallin et le substrat pendant la gravure sont insuffisants pour garantir une bonne homogénéité de la gravure. De plus, une opération de soudure est nécessaire.

La présente invention vise à remédier aux inconvénients précités, ou au moins à les atténuer, et propose à cette fin un procédé selon la revendication 1, des modes de réalisation particuliers étant définis dans les revendications dépendantes.

D'autres caractéristiques et avantages de la présente invention apparaîtront à la lecture de la description détaillée suivante faite en référence aux dessins annexés dans lesquels :
- les figures 1 à 8 sont des vues en coupe transversale montrant des étapes successives d'un procédé de fabrication d'un ou plusieurs spiraux selon l'invention ;
- la figure 9 est une vue de dessus d'un spiral montrant schématiquement la localisation de ses points d'attache à un support pendant sa fabrication.

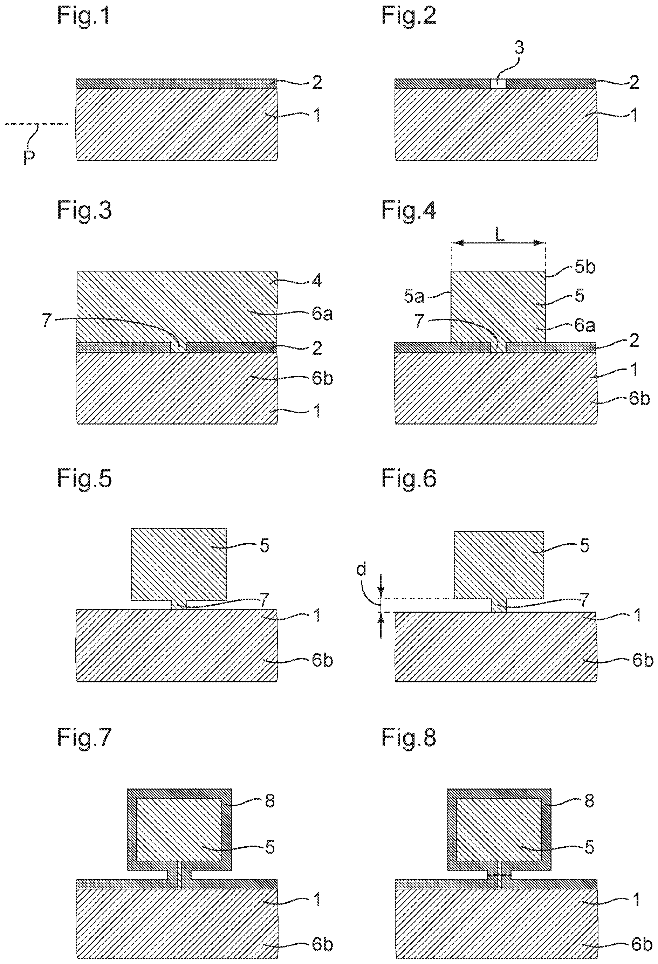

Une première étape d'un procédé selon un mode de réalisation préféré de l'invention, représentée à la figure 1, consiste à se munir d'un substrat en silicium 1 s'étendant dans un plan P et portant sur sa face supérieure parallèle au plan P une couche d'oxyde de silicium (SiO₂) 2. L'épaisseur (hauteur) du substrat 1 peut correspondre à celle du ou des spiraux à fabriquer, soit typiquement 120 µm, ou être plus faible que celle du ou des spiraux à fabriquer selon que ces derniers sont réalisés dans le substrat 1 ou dans une autre couche comme il sera décrit plus loin. Dans le deuxième cas, le substrat 1 est toutefois suffisamment épais, typiquement de quelques dizaines de micromètres, pour prévenir sa déformation. L'épaisseur de la couche d'oxyde de silicium 2 est par exemple de 3 µm. Le silicium du substrat 1 peut être monocristallin, quelle que soit son orientation cristalline, polycristallin ou amorphe.

La couche d'oxyde de silicium 2 est ensuite structurée, par exemple par photolithographie, pour y former des trous traversants 3 comme montré à la figure 2, un seul de ces trous traversants 3 étant visible sur la figure 2. Concrètement, la couche 2 est gravée à travers un masque, la gravure pouvant être humide ou sèche mais étant de préférence sèche, à plasma, pour une meilleure précision. Le diamètre des trous 3 ainsi réalisés est de préférence inférieur à la largeur de la lame des spiraux à fabriquer. Typiquement, les trous 3 ont un diamètre d'environ 5 µm et la largeur de la lame des spiraux à fabriquer est d'environ 30 µm.

A une étape suivante (figure 3), on fait croître sur la couche d'oxyde de silicium 2, par exemple par épitaxie, du silicium monocristallin, polycristallin ou amorphe pour former une couche de silicium 4. Durant cette étape, les trous 3 de la couche d'oxyde de silicium 2 sont remplis par le silicium de la couche 4. L'épaisseur de la couche de silicium 4 correspond à celle du ou des spiraux à fabriquer, soit typiquement 120 µm, ou peut être inférieure à celle du ou des spiraux à fabriquer selon que ces derniers sont réalisés dans cette couche 4 ou dans le substrat 1. Dans le deuxième cas, la couche 4 est toutefois suffisamment épaisse, typiquement de quelques dizaines de micromètres, pour prévenir sa déformation. En particulier dans le premier cas, et selon l'état de la surface supérieure de la couche 4, on peut prévoir un polissage de cette surface supérieure, tel qu'un polissage mécano-chimique CMP (Chemical Mechanical Polishing), visant à supprimer les défauts de croissance liés à la structuration de la couche d'oxyde de silicium 2 et/ou à ajuster l'épaisseur de la couche de silicium 4.

Ensuite (cf. figure 4), soit la couche de silicium 4 soit le substrat en silicium 1 est structuré par gravure ionique réactive profonde (DRIE) afin de former un ou des spiraux 5. Dans la présente description, celui parmi la couche 4 et le substrat 1 qui est structuré est appelé « couche de gravure » et désigné par le repère 6a, et l'autre parmi la couche 4 et le substrat 1 est appelé « support » et désigné par le repère 6b. La figure 4 représente la variante dans laquelle les spiraux 5 sont gravés dans la couche 4 et le substrat 1 constitue le support 6b. A la figure 4, seule la section transversale d'une spire d'un de ces spiraux 5 est illustrée. Chaque spiral 5 peut être formé simultanément et d'un seul tenant avec sa virole pour son montage ultérieur sur un axe de balancier.

Pendant cette étape de DRIE, un masque est utilisé pour la gravure et la température à coeur du plasma est de l'ordre de 180°C. Le support 6b est refroidi à environ 20°C, par exemple au moyen d'hélium balayant la face du support 6b la plus éloignée de la couche de gravure 6a et/ou au moyen d'une circulation de liquide de refroidissement thermostaté refroidissant le mandrin qui supporte le support 6b. Ce refroidissement du support 6b refroidit le masque à travers la couche d'oxyde de silicium 2 et la couche de gravure 6a, évitant de la sorte que le masque brûle et que la qualité de la gravure soit affectée. Un tel refroidissement du masque est permis notamment par les échanges thermiques entre le support 6b et la couche de gravure 6a. Le contact continu entre le support 6b et la couche de gravure 6a, par l'intermédiaire de la couche d'oxyde de silicium 2, améliore ces échanges thermiques par rapport au procédé selon le brevet EP 0732635. Dans ce dernier, en effet, dans les zones de gravure le substrat et la plaque de matériau cristallin ne sont reliés que par des ponts de matière pendant la gravure en raison des cavités préalablement creusées dans le substrat. Ceci nuit aux échanges thermiques et à l'homogénéité de la gravure pendant la fabrication.

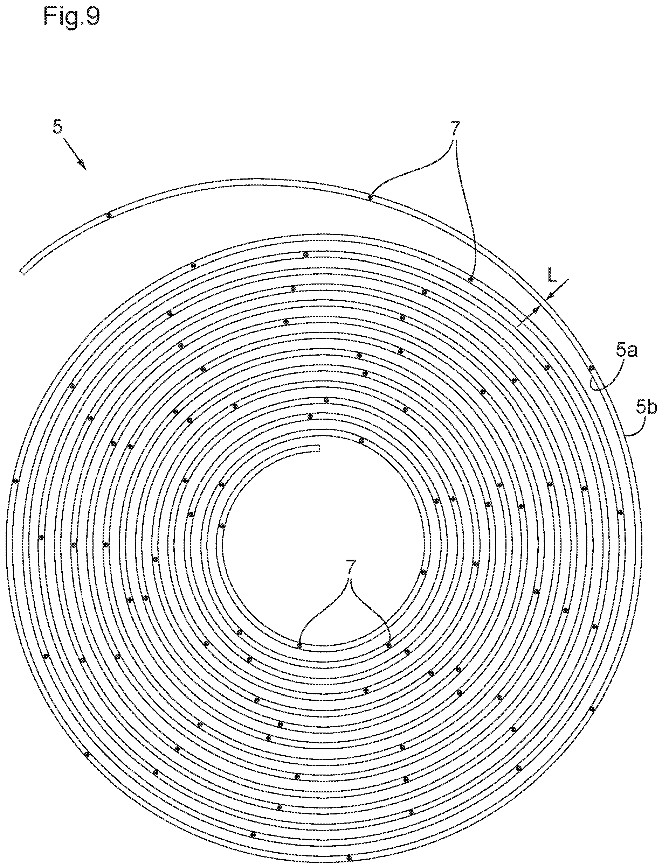

Dans la présente invention, les spiraux 5 formés dans la couche de gravure 6a sont reliés au support 6b perpendiculairement au plan P par la couche d'oxyde de silicium 2 et par le silicium remplissant les trous 3. Ce silicium remplissant les trous 3 constitue des ponts de matière 7 qui sont monolithiques avec les spiraux 5 et le support 6b. Ces ponts de matière 7, qui ont la forme et les dimensions des trous 3, sont typiquement cylindriques à section circulaire mais ils peuvent avoir une autre forme telle que celle d'un cylindre à section polygonale ou à section oblongue. Ils sont situés sur le dessous ou le dessus des spiraux 5. De préférence, en projection dans le plan P, chaque pont de matière 7 est entièrement situé entre les deux flancs 5a, 5b de la lame d'un spiral 5, occupe seulement une partie de la largeur L de cette lame, par exemple moins de 50% voire moins de 30% voire encore moins de 20% de cette largeur L, et est centré par rapport aux deux flancs 5a, 5b pour être au droit de la fibre neutre de la lame. De préférence, également, ces ponts de matière 7 sont répartis sur toute la longueur de chaque spiral 5, comme montré schématiquement à la figure 9.

A une étape suivante du procédé selon l'invention, on élimine la couche d'oxyde de silicium 2 (figure 5), par exemple par attaque chimique. Les spiraux 5 ne sont alors reliés au support 6b que par les ponts de matière 7.

Puis on met en oeuvre le procédé décrit dans la demande de brevet EP 3181938 afin de donner aux spiraux 5 une raideur prédéterminée. Plus précisément, on détache quelques spiraux 5 du support 6b, on les couple à des balanciers d'inertie prédéterminée, on mesure les fréquences d'oscillation, on en calcule la moyenne, on en déduit une valeur de raideur pour les spiraux 5, on calcule une épaisseur de matériau à retirer des spiraux 5 pour obtenir la raideur prédéterminée et on retire cette épaisseur de matériau des spiraux 5 attachés au support 6b, ces étapes pouvant être répétées afin d'affiner la précision dimensionnelle des spiraux 5. Pour retirer l'épaisseur de matériau calculée, on oxyde puis on désoxyde les spiraux 5. Pour ce faire, on place l'ensemble support 6b - spiraux 5 dans un four pour le soumettre à une température comprise entre 800 et 1200°C et à une atmosphère oxydante jusqu'à obtenir une épaisseur prédéterminée d'oxyde de silicium (SiO₂) sur ses surfaces. Cette couche d'oxyde de silicium se forme en consommant du silicium sur une profondeur correspondant environ à la moitié de son épaisseur. Après ce traitement thermique, on élimine la couche d'oxyde de silicium, par exemple par attaque chimique, afin d'obtenir des spiraux 5 ayant des dimensions réduites correspondant à la raideur prédéterminée (figure 6). Cette oxydation/désoxydation des spiraux 5 permet aussi de réduire fortement les ondulations que crée la gravure ionique réactive profonde sur les flancs des spiraux 5, comme expliqué dans la demande de brevet EP 3181938.

Une étape suivante du procédé selon l'invention, représentée à la figure 7, peut consister à revêtir les spiraux 5 d'une couche de compensation thermique 8 faite en un matériau présentant un premier coefficient thermique du module d'élasticité de signe opposé à celui du silicium, selon l'enseignement du brevet EP 1422436. Cette couche de compensation thermique 8 est typiquement en oxyde de silicium (SiO₂). Elle peut être formée par oxydation thermique, comme décrit ci-dessus, en plaçant l'ensemble support 6b - spiraux 5 dans un four pour le soumettre à une température comprise entre 800 et 1200°C et à une atmosphère oxydante jusqu'à obtenir une épaisseur prédéterminée d'oxyde de silicium sur ses surfaces. Etant donné que l'oxyde de silicium, en se formant, consomme du silicium sur une profondeur correspondant à environ la moitié de son épaisseur, la distance d entre les spiraux 5 et le support 6b à la figure 6 doit être supérieure à l'épaisseur de la couche de compensation thermique 8 afin d'éviter qu'ils se touchent. Ainsi, par exemple, cette distance d est supérieure à 3 µm, voire à 4 µm, voire à 5 ou 6 µm, pour une épaisseur de la couche de compensation thermique 8 de 3 µm. La couche de compensation thermique 8, en particulier lorsqu'elle est en oxyde de silicium, a aussi pour fonction d'augmenter la résistance mécanique des spiraux 5.

Le nombre des ponts de matière 7 par spiral est choisi suffisamment grand pour empêcher les spires de s'affaisser et d'entrer en contact avec le support 6b pendant les passages dans le four. Ce nombre dépend notamment de la raideur des spiraux 5. Il peut être réduit en disposant l'ensemble support 6b - spiraux 5 de telle sorte que le support 6b soit au-dessus des spiraux 5 pendant les phases d'oxydation.

En plus des ponts de matière 7 répartis le long de chaque spiral 5, des ponts de matière peuvent être prévus sur la virole et/ou sur une extrémité extérieure rigide du spiral destinée à être fixée à un pont de bâti. On peut aussi conserver des ponts de matière reliant latéralement les spiraux 5 entre eux de sorte à former une dentelle.

Ces ponts de matière ou attaches 7 reliant les spiraux 5 au support 6b permettent d'éviter ou d'au moins diminuer les déformations permanentes (plastiques) des spiraux 5 pendant les phases d'oxydation thermique. En effet, le silicium est un matériau fragile à température ambiante - il ne peut se déformer qu'élastiquement - mais il semble présenter un comportement ductile à partir de températures de l'ordre de 800°C à 1000°C. Des déformations initialement élastiques et réversibles des spiraux 5 lors de leur placement dans le four peuvent devenir permanentes pendant le traitement thermique. Le support 6b et les ponts de matière 7 limitent les déformations des spiraux 5, lesquels pourront donc avoir une forme proche de leur forme théorique à l'issue de leur fabrication.

A une dernière étape du procédé selon l'invention, représentée à la figure 8, on libère les spiraux 5 du support 6b en cassant les ponts de matière 7 au moyen d'un outil. Dans une variante, on peut libérer les spiraux 5 en éliminant les ponts de matière 7 par une opération de gravure avec masque mise en oeuvre depuis la face du support 6b la plus éloignée des spiraux 5.

Quel que soit le moyen utilisé pour libérer les spiraux 5, les zones des spiraux 5 où se trouvent les ponts de matière 7 ne seront pas recouvertes par la couche de compensation thermique 8. Toutefois, du fait que ces zones sont situées au droit de la fibre neutre des spiraux 5, elles seront peu sollicitées en flexion pendant le fonctionnement des spiraux 5. Elles peuvent donc avoir une moindre résistance mécanique. Quant à la compensation thermique, son utilité est grande sur les flancs des spiraux 5 mais moindre sur le dessus et le dessous. L'absence de couche de compensation thermique au niveau des zones des ponts de matière 7 affectera donc peu le comportement des spiraux 5 vis-à-vis des variations de température.

Si l'on souhaite néanmoins éviter que des zones des spiraux 5 soient sans couche de compensation thermique après la rupture ou l'élimination des ponts de matière 7, on peut diminuer le diamètre des trous 3 et donc des ponts de matière 7 afin que ces derniers ne soient plus constitués que d'oxyde de silicium après la formation de la couche de compensation thermique 8.

Dans une variante de l'invention, les ponts de matière 7 de chaque spiral 5 sont remplacés par un seul pont de matière formant, en projection dans le plan P, une spirale continue qui suit la forme spiralée de la lame du spiral 5. De préférence, toujours en projection dans le plan P, ce pont de matière est situé entièrement entre les deux flancs 5a, 5b de la lame, occupe seulement une partie de la largeur L de cette lame, par exemple moins de 50% voire moins de 30% voire encore moins de 20% de cette largeur L, et est centrée par rapport aux deux flancs 5a, 5b de la lame.

La présente invention n'est pas limitée aux matériaux, silicium et oxyde de silicium, mentionnés ci-dessus. Il va de soi qu'elle pourrait s'appliquer à d'autres matériaux, notamment, pour ce qui concerne la couche de gravure 6a, à tout matériau pouvant être structuré par gravure. La présente invention est particulièrement avantageuse pour les matériaux, tels que le silicium, les verres ou les céramiques, qui sont fragiles à température ambiante et ductiles ou potentiellement ductiles à température élevée.

## Revendications

1. Procédé de fabrication d'au moins un spiral (5) comprenant les étapes successives suivantes :
a) se munir d'un substrat (1) s'étendant dans un plan déterminé (P) et portant une première couche (2) parallèle au plan déterminé (P),
b) former au moins un trou traversant (3) dans la première couche (2),
c) déposer une deuxième couche (4) sur la première couche (2), la deuxième couche (4) remplissant l'au moins un trou traversant (3) pour former au moins un pont de matière (7),
d) graver au moins un spiral (5) dans une couche de gravure (6a) constituée par la deuxième couche (4) ou par le substrat (1), celui parmi la deuxième couche (4) et le substrat (1) dans lequel l'au moins un spiral (5) n'est pas gravé constituant un support (6b), l'au moins un pont de matière (7) reliant l'au moins un spiral (5) au support (6b) perpendiculairement au plan déterminé (P) et étant réparti sur sensiblement toute la longueur du ou de chaque spiral (5),
e) éliminer la première couche (2), l'au moins un spiral (5) restant attaché au support (6b) par l'au moins un pont de matière (7),
f) soumettre l'au moins un spiral (5) à au moins un traitement thermique,
g) détacher l'au moins un spiral (5) du support (6b).

2. Procédé selon la revendication 1, **caractérisé en ce que** le ou l'un au moins des traitements thermiques est réalisé dans un four.

3. Procédé selon la revendication 1 ou 2, **caractérisé en ce que** le ou l'un au moins des traitements thermiques est réalisé à une température d'au moins 800°C, de préférence d'au moins 900°C, de préférence d'au moins 1000°C, de préférence d'au moins 1 100°C, de préférence d'au moins 1200°C.

4. Procédé selon l'une quelconque des revendications 1 à 3, **caractérisé en ce que** le ou l'un au moins des traitements thermiques comprend une oxydation thermique.

5. Procédé selon la revendication 4, **caractérisé en ce qu'**il comprend, entre les étapes f) et g), une étape de désoxydation, l'oxydation thermique et la désoxydation permettant de diminuer les dimensions de l'au moins un spiral (5) pour l'obtention d'une raideur prédéterminée.

6. Procédé selon la revendication 4, **caractérisé en ce que** l'oxydation thermique vise à former une couche de compensation thermique (8) sur l'au moins un spiral (5).

7. Procédé selon l'une quelconque des revendications 1 à 6, **caractérisé en ce que** la couche de gravure (6a) est en un matériau qui est fragile à température ambiante.

8. Procédé selon l'une quelconque des revendications 1 à 7, **caractérisé en ce que** la couche de gravure (6a) est en silicium ou à base de silicium.

9. Procédé selon l'une quelconque des revendications 1 à 7, **caractérisé en ce que** la couche de gravure (6a) est en verre ou à base de verre.

10. Procédé selon l'une quelconque des revendications 1 à 7, **caractérisé en ce que** la couche de gravure (6a) est en céramique ou à base de céramique.

11. Procédé selon l'une quelconque des revendications 1 à 10, **caractérisé en ce que** le support (6b) est en silicium ou à base de silicium.

12. Procédé selon l'une quelconque des revendications 1 à 11, **caractérisé en ce que** la première couche (2) est en oxyde de silicium ou à base d'oxyde de silicium.

13. Procédé selon l'une quelconque des revendications 1 à 12, **caractérisé en ce que** l'étape b) est réalisée par photolithographie.

14. Procédé selon l'une quelconque des revendications 1 à 13, **caractérisé en ce que** l'étape c) est réalisée par épitaxie.

15. Procédé selon l'une quelconque des revendications 1 à 14, **caractérisé en ce que** l'étape d) est réalisée par gravure ionique réactive profonde.

16. Procédé selon l'une quelconque des revendications 1 à 15, **caractérisé en ce que** le support (6b) est refroidi pendant l'étape d).

17. Procédé selon l'une quelconque des revendications 1 à 16, **caractérisé en ce qu'**en projection dans le plan déterminé (P), le ou chaque pont de matière (7) est entièrement situé entre les deux flancs (5a, 5b) d'une lame de l'au moins un spiral (5) et occupe seulement une partie de la largeur (L) de cette lame.

18. Procédé selon l'une quelconque des revendications 1 à 17, **caractérisé en ce qu'**en projection dans le plan déterminé (P), le ou chaque pont de matière (7) est sensiblement centré par rapport aux deux flancs (5a, 5b) d'une lame de l'au moins un spiral (5).

## Patentansprüche

1. Verfahren zur Herstellung mindestens einer Spiralfeder (5), das die folgenden aufeinanderfolgenden Schritte umfasst:
a) Bereitstellen eines Substrats (1), das sich in einer bestimmten Ebene (P) erstreckt und eine erste Schicht (2) trägt, die parallel zur bestimmten Ebene (P) ist,
b) Bilden mindestens eines Durchgangslochs (3) in der ersten Schicht (2),
c) Aufbringen einer zweiten Schicht (4) auf der ersten Schicht (2), wobei die zweite Schicht (4) das mindestens eine Durchgangsloch (3) füllt, um mindestens eine Materialbrücke (7) zu bilden,
d) Ätzen mindestens einer Spiralfeder (5) in einer Ätzschicht (6a), die aus der zweiten Schicht (4) oder aus dem Substrat (1) besteht, wobei diejenige bzw. dasjenige von der zweiten Schicht (4) und dem Substrat (1), in welche bzw. welches die mindestens eine Spiralfeder (5) nicht geätzt wird, einen Träger (6b) bildet, wobei die mindestens eine Materialbrücke (7) die mindestens eine Spiralfeder (5) mit dem Träger (6b) senkrecht zur bestimmten Ebene (P) verbindet und über im Wesentlichen die gesamte Länge der oder jeder Spiralfeder (5) verteilt ist,
e) Beseitigen der ersten Schicht (2), wobei die mindestens eine Spiralfeder (5) über die mindestens eine Materialbrücke (7) an dem Träger (6b) befestigt bleibt,
f) Unterziehen der mindestens einen Spiralfeder (5) gegenüber mindestens einer Wärmebehandlung,
g) Ablösen der mindestens einen Spiralfeder (5) von dem Träger (6b).

2. Verfahren nach Anspruch 1, **dadurch gekennzeichnet, dass** die oder mindestens eine der Wärmebehandlungen in einem Ofen ausgeführt wird.

3. Verfahren nach Anspruch 1 oder 2, **dadurch gekennzeichnet, dass** die oder mindestens eine der Wärmebehandlungen bei einer Temperatur von mindestens 800 °C, vorzugsweise mindestens 900 °C, vorzugsweise mindestens 1000 °C, vorzugsweise mindestens 1100 °C, vorzugsweise mindestens 1200 °C, ausgeführt wird.

4. Verfahren nach einem der Ansprüche 1 bis 3, **dadurch gekennzeichnet, dass** die oder mindestens eine der Wärmebehandlungen eine thermische Oxidation umfasst.

5. Verfahren nach Anspruch 4, **dadurch gekennzeichnet, dass** es zwischen den Schritten f) und g) einen Desoxidationsschritt umfasst, wobei die thermische Oxidation und die Desoxidation das Verkleinern der Abmessungen der mindestens einen Spiralfeder (5) für den Erhalt einer vorbestimmten Steifigkeit ermöglichen.

6. Verfahren nach Anspruch 4, **dadurch gekennzeichnet, dass** die thermische Oxidation auf das Bilden einer thermischen Kompensationsschicht (8) auf der mindestens einen Spiralfeder (5) abzielt.

7. Verfahren nach einem der Ansprüche 1 bis 6, **dadurch gekennzeichnet, dass** die Ätzschicht (6a) aus einem Material besteht, das bei Umgebungstemperatur zerbrechlich ist.

8. Verfahren nach einem der Ansprüche 1 bis 7, **dadurch gekennzeichnet, dass** die Ätzschicht (6a) aus Silizium besteht oder auf Siliziumbasis ist.

9. Verfahren nach einem der Ansprüche 1 bis 7, **dadurch gekennzeichnet, dass** die Ätzschicht (6a) aus Glas besteht oder auf Glasbasis ist.

10. Verfahren nach einem der Ansprüche 1 bis 7, **dadurch gekennzeichnet, dass** die Ätzschicht (6a) aus Keramik besteht oder auf Keramikbasis ist.

11. Verfahren nach einem der Ansprüche 1 bis 10, **dadurch gekennzeichnet, dass** der Träger (6b) aus Silizium besteht oder auf Siliziumbasis ist.

12. Verfahren nach einem der Ansprüche 1 bis 11, **dadurch gekennzeichnet, dass** die erste Schicht (2) aus Siliziumoxid besteht oder auf Siliziumoxidbasis ist.

13. Verfahren nach einem der Ansprüche 1 bis 12, **dadurch gekennzeichnet, dass** der Schritt b) durch Fotolithographie ausgeführt wird.

14. Verfahren nach einem der Ansprüche 1 bis 13, **dadurch gekennzeichnet, dass** der Schritt c) durch Epitaxie ausgeführt wird.

15. Verfahren nach einem der Ansprüche 1 bis 14, **dadurch gekennzeichnet, dass** der Schritt d) durch reaktives Ionentiefenätzen ausgeführt wird.

16. Verfahren nach einem der Ansprüche 1 bis 15, **dadurch gekennzeichnet, dass** der Träger (6b) während des Schritts d) gekühlt wird.

17. Verfahren nach einem der Ansprüche 1 bis 16, **dadurch gekennzeichnet, dass** in der Projektion in der bestimmten Ebene (P) die oder jede Materialbrücke (7) sich vollständig zwischen den zwei Flanken (5a, 5b) einer Klinge der mindestens einen Spiralfeder (5) befindet und lediglich einen Teil der Breite (L) dieser Klinge einnimmt.

18. Verfahren nach einem der Ansprüche 1 bis 17, **dadurch gekennzeichnet, dass** in der Projektion in der bestimmten Ebene (P) die oder jede Materialbrücke (7) in Bezug auf die zwei Flanken (5a, 5b) einer Klinge der mindestens einen Spiralfeder (5) im Wesentlichen zentriert ist.

## Claims

1. Method for manufacturing at least one spiral spring (5) comprising the following successive steps:
a) providing a substrate (1) extending in a determined plane (P) and bearing a first layer (2) parallel to the determined plane (P),
b) forming at least one through hole (3) in the first layer (2),
c) depositing a second layer (4) on the first layer (2), the second layer (4) filling the at least one through hole (3) to form at least one bridge of material (7),
d) etching at least one spiral spring (5) in an etching layer (6a) consisting of the second layer (4) or of the substrate (1), the one among the second layer (4) and the substrate (1) in which the at least one spiral spring (5) is not etched forming a support (6b), the at least one bridge of material (7) linking the at least one spiral spring (5) to the support (6b) perpendicularly to the determined plane (P) and being distributed over substantially the whole length of the or each spiral spring (5),
e) eliminating the first layer (2), the at least one spiral spring (5) remaining attached to the support (6b) by the at least one bridge of material (7),
f) subjecting the at least one spiral spring (5) to at least one thermal treatment,
g) detaching the at least one spiral spring (5) from the support (6b).

2. Method according to claim 1, **characterized in that** the thermal treatment or at least one of the thermal treatments is performed in a furnace.

3. Method according to claim 1 or 2, **characterized in that** the thermal treatment or at least one of the thermal treatments is performed at a temperature of at least 800°C, preferably of at least 900°C, preferably of at least 1000°C, preferably of at least 1100°C, preferably of at least 1200°C.

4. Method according to any of claims 1 to 3, **characterized in that** the thermal treatment or at least one of the thermal treatments comprises a thermal oxidation.

5. Method according to claim 4, **characterized in that** it comprises, between the steps f) and g), a deoxidation step, wherein the thermal oxidation and the deoxidation enable to decrease the dimensions of the at least one spiral spring (5) to obtain a predetermined stiffness.

6. Method according to claim 4, **characterized in that** the thermal oxidation aims at forming a thermal compensation layer (8) on the at least one spiral spring (5).

7. Method according to any of claims 1 to 6, **characterized in that** the etching layer (6a) is made of a material that is brittle at room temperature.

8. Method according to any of claims 1 to 7, **characterized in that** the etching layer (6a) is made of silicon or of a silicon-based material.

9. Method according to any of claims 1 to 7, **characterized in that** the etching layer (6a) is made of glass or of a glass-based material.

10. Method according to any of claims 1 to 7, **characterized in that** the etching layer (6a) is made of ceramic or of a ceramic-based material.

11. Method according to any of claims 1 to 10, **characterized in that** the support (6b) is made of silicon or of a silicon-based material.

12. Method according to any of claims 1 to 11, **characterized in that** the first layer (2) is made of silicon oxide or of a silicon-oxide-based material.

13. Method according to any of claims 1 to 12, **characterized in that** the step b) is performed by photolithography.

14. Method according to any of claims 1 to 13, **characterized in that** the step c) is performed by epitaxy.

15. Method according to any of claims 1 to 14, **characterized in that** the step d) is performed by deep reactive ion etching.

16. Method according to any of claims 1 to 15, **characterized in that** the support (6b) is cooled during the step d).

17. Method according to any of claims 1 to 16, **characterized in that** in projection into the determined plane (P), the or each bridge of material (7) is entirely located between the two sides (5a, 5b) of a blade of the at least one spiral spring (5) and takes up only part of the width (L) of this blade.

18. Method according to any of claims 1 to 17, **characterized in that** in projection into the determined plane (P), the or each bridge of material (7) is substantially centered with respect to the two sides (5a, 5b) of a blade of the at least one spiral spring (5).
